# EUROPÄISCHE PATENTSCHRIFT

(11) **EP 1 222 696 B1**
(45) Veröffentlichungstag und Bekanntmachung des Hinweises auf die Patenterteilung: **30.07.2014**
(21) Anmeldenummer: 00972599.5
(22) Anmeldetag: 21.09.2000
(51) Int. Cl.: H01L 33/02, H01L 33/14, H01L 33/22, H01L 33/42

(54) **OBERFLÄCHENSTRUKTURIERTE LICHTEMISSIONSDIODE MIT VERBESSERTER STROMEINKOPPLUNG**
SURFACE STRUCTURED LIGHT-EMITTING DIODE WITH IMPROVED CURRENT COUPLING
DIODE ELECTROLUMINESCENTE A STRUCTURE SURFACIQUE AVEC INJECTION DE COURANT AMELIOREE

(30) Priorität: 30.09.1999 DE 19947030
(43) Veröffentlichungstag der Anmeldung: 17.07.2002
(73) Patentinhaber: OSRAM Opto Semiconductors GmbH, 93055 Regensburg (DE)
(72) Erfinder: WIRTH, Ralph, 93049 Regensburg (DE); STREUBEL, Klaus, 93164 Laaber (DE)
(74) Vertreter: Epping - Hermann - Fischer
(86) Internationale Anmeldenummer: PCT/DE2000/003291
(87) Internationale Veröffentlichungsnummer: WO 2001/024280

(56) Entgegenhaltungen:
- EP-A- 0 405 757
- US-A- 5 698 865
- US-A- 5 744 828
- US-A- 5 779 924
- CUEVAS A ET AL: "26-PERCENT EFFICIENT POINT-JUNCTION CONCENTRATOR SOLAR CELLS WITH AFRONT METAL GRID" IEEE ELECTRON DEVICE LETTERS,US,IEEE INC. NEW YORK, Bd. 11, Nr. 1, 1990, Seiten 6-8, XP000085361 ISSN: 0741-3106

## Beschreibung

Die Erfindung betrifft eine Lichtemissionsdiode nach dem Oberbegriff des Patentanspruchs 1. Insbesondere betrifft die Erfindung eine oberflächenstrukturierte Lichtemissionsdiode, bei der zur Verbesserung der Homogenität der Stromzufuhr eine elektrische Kontaktschicht eine laterale Struktur aufweist, mit welcher eine im wesentlichen homogene Einkopplung des elektrischen Stroms in die Lichtemissionsdiode erzielt werden kann.

Aus den Druckschriften US-A-5,698,865 und US-A-5,744,828 sind Lichtemissionsdioden bekannt, die an einer Oberfläche eine Kontaktstruktur mit einer zentralen Kontaktfläche und von der Kontaktfläche ausgehenden schmalen Kontakstegen aufweisen, um die Stromaufweitung zu verbessern.

Lichtemissionsdioden, wie Halbleiter-Leuchtdioden (LED), zeichnen sich insbesondere dadurch aus, daß je nach Materialsystem der interne Umwandlungswirkungsgrad von zugeführter elektrischer Energie in Strahlungsenergie sehr groß, d.h. durchaus größer als 80 % sein kann. Die effektive Lichtauskopplung aus dem Halbleiterkristall wird jedoch durch den hohen Brechungsindexsprung zwischen dem Halbleitermaterial (typischerweise n = 3,5) und dem umgebenden Harzguß-Material (typischerweise n = 1,5) erschwert. Der sich daraus ergebende kleine Totalreflexionswinkel an der Grenzfläche Halbleiter-Harzvergußmaterial von ca. 26° führt dazu, daß nur ein Bruchteil des erzeugten Lichts ausgekoppelt werden kann. In der typischerweise bei der Herstellung verwendeten einfachen würfelförmigen Gestalt der LED bleibt ein Strahlungsbündel, das nicht in dem ca. 26° weiten Auskoppelkegel emittiert wird, in dem Halbleiterkristall gefangen, da sein Winkel zu den Oberflächennormalen auch durch Vielfachreflexion nicht verändert wird. Das Strahlungsbündel wird infolgedessen früher oder später durch Absorption vor allem im Bereich des Kontakts, der aktiven Zone oder im Substrat verlorengehen. Insbesondere bei InGaAlP-LEDs stellt das absorbierende GaAs-Substrat ein besonderes Problem dar. In konventionellen LEDs dieser Art gehen die von der aktiven Zone in Richtung zur Oberfläche der LED emittierte Strahlen, die außerhalb des Auskoppelkegels liegen, mit hoher Wahrscheinlichkeit im Substrat durch Absorption verloren.

Der in der Praxis am häufigsten verwendete Weg, das geschilderte Problem zu mildern, besteht darin, eine dicke Halbleiter-Schicht an der Oberseite der LED aufzubringen. Dies ermöglicht die teilweise Nutzung der seitlichen Auskoppelkegel der emittierten Lichtstrahlung.

In der US-A-5,008,718 wird vorgeschlagen, in einer AlGaInP-LED hauptsächlich aus Gründen der lateralen Verbreiterung des durch einen elektrischen Kontakt injizierten Stromes eine elektrisch leitfähige und für die emittierte Lichtstrahlung transparente GaP-Schicht auf den aktiven, lichtemittierenden Schichten aufzubringen. Auf den vorteilhaften Nebeneffekt der Verminderung der internen Totalreflexion und die Ermöglichung der seitlichen Auskopplung der Lichtstrahlung durch die Wirkung der dicken GaP-Schicht wird an anderer Stelle hingewiesen. Zusätzlich wird vorgeschlagen, das für die emittierte Lichtstrahlung undurchsichtige GaAs-Substrat durch Abätzen zu entfernen und durch mindestens eine transparente Substratschicht aus einem geeigneten Material, wie GaP, zu ersetzen.

Auch in der US-A-5,233,204 wird die Verwendung einer oder mehrerer dicker und transparenter Schichten in einer Lichtemissionsdiode vorgeschlagen. Für die Anordnung und Anzahl dieser transparenten Schichten werden verschiedene Konfigurationen beschrieben. Unter anderem wird eine unterhalb der aktiven, lichterzeugenden Schicht angeordnete, sich in Richtung auf das Substrat verjüngende und trichterförmig gebildete Schicht vorgeschlagen (Fig. 10).

Bei ersten Computersimulationen hat sich bereits gezeigt, daß eine Oberflächenstrukturierung der obersten dicken, transparenten Halbleiterschicht zu verbesserten Werten für die Lichtauskopplung führt. Insbesondere eine Oberflächenstrukturierung bestehend aus vorzugsweise regelmäßig angeordneten n-seitigen Prismen, Pyramiden oder Pyramidenstümpfen, Zylindern, Kegeln, Kegelstümpfen und dergleichen hat zu einer deutlichen Verbesserung der Lichtauskopplung geführt. Das liegt daran, daß die zunächst steil nach oben verlaufenden Strahlen an den strukturierten Oberflächen reflektiert werden, mit jeder der Reflexionen jedoch flacher verlaufen, so daß sie schließlich seitlich aus den Seitenwänden der strukturierten Bereiche der Oberfläche ausgekoppelt werden.

Solche oberflächenstrukturierten Lichtemissionsdioden wurden zunächst so hergestellt, daß nach dem Aufwachsen der lichterzeugenden Halbleiterschichten auf einem Halbleitersubstrat und der oberen dicken, transparenten Halbleiterschicht eine zentrale elektrische Kontaktfläche auf die Oberfläche der dicken Halbleiterschicht aufgebracht wurde. Anschließend wurde in den Bereichen außerhalb der zentralen Kontaktfläche durch Ätztechnik die Strukturierung der Oberfläche der dicken Halbleiterschicht vorgenommen, worauf die Substratrückseite gedünnt und mit einem Rückseitenkontakt versehen wurde. Diese Vorgehensweise erwies sich jedoch als nachteilig, da die dicke Halbleiterschicht, das sogenannte Fenster, durch die Strukturierung fragmentiert wird, wodurch sich die Stromaufweitung verschlechtert. Somit findet keine ausreichende Verteilung des elektrischen Stromes in Bereiche außerhalb der zentralen Kontaktfläche statt, so daß die durch die Strukturierung verbesserte Lichtauskopplung durch die mangelnde Stromaufweitung kompensiert wird, so daß die Steigerung des Gesamtlichtflusses nicht wie gewünscht ausfällt.

Es ist demzufolge Aufgabe der vorliegenden Erfindung, eine Lichtemissionsdiode mit einer hohen effektiven Lichtauskopplung anzugeben. Insbesondere ist es eine Aufgabe der vorliegenden Erfindung, bei einer Lichtemissionsdiode gleichzeitig für eine gute räumliche Verteilung des initiierten elektrischen Stromes und für eine gute Auskopplung der optischen Lichtstrahlung zu sorgen.

Diese Aufgabe wird mit den kennzeichnenden Merkmalen des Patentanspruchs 1 gelöst.

Demgemäß beschreibt die vorliegende Erfindung eine Lichtemissionsdiode mit einer Halbleiterschichtstruktur, enthaltend ein Substrat und mindestens eine auf dem Substrat geformte lichterzeugende Schicht und eine auf die lichterzeugende Schicht aufgebrachte, transparente Stromaufweitungsschicht, einer ersten elektrischen Kontaktschicht auf der Substratrückseite, und einer zweiten elektrischen Kontaktschicht, die auf der Stromaufweitungsschicht angeordnet ist, wobei die Oberfläche der Stromaufweitungsschicht eine vertikale Strukturierung zur Verbesserung der Lichtauskopplung aufweist, und die zweite elektrische Kontaktschicht eine laterale Struktur aufweist, mit welcher eine im wesentlichen homogene Einkopplung des elektrischen Stromes in die Stromaufweitungsschicht erzielt werden kann. Die Stromaufweitungsschicht ist vorzugsweise relativ dick, insbesondere in einem Bereich zwischen 5 und 80 µm.

Die zweite elektrische Kontaktschicht weist eine zentrale, insbesondere kreisrunde Kontaktfläche und eine zu dem Mittelpunkt der zentralen Kontaktfläche rotationssymmetrische Kontaktstruktur aus relativ schmalen Kontaktstegen und/oder Kontaktpunkten um die zentrale Kontaktfläche herum auf. Die Rotationssymmetrie der Kontaktstruktur kann dabei ganzzahlig sein und insbesondere der Rotationssymmetrie der Lichtemissionsdiode entsprechen. Der Regelfall ist eine rechteckförmige oder quadratische Lichtemissionsdiode, bei der die Kontaktstruktur eine vierzählige Symmetrie aufweist.

Die zweite elektrische Kontaktschicht ist in sich nicht zusammenhängend ausgebildet, wobei die nicht zusammenhängenden Abschnitte durch eine zusätzliche transparente, leitfähige Materialschicht, beispielsweise aus Indiumzinnoxid (ITO), untereinander verbunden sind.

Die Erfindung beruht somit auf einer Kombination einer Oberflächenstrukturierung des Halbleiters, die zur Lichtauskopplung beiträgt und einer verbesserten Stromaufweitungsschicht, die durch eine im weitesten Sinne zu einem metallischen Kontaktgitter geformte zweite elektrische Kontaktschicht gewährleistet wird. Unter Gitter ist hier und im folgenden nicht allein ein streng periodisches, geschlossenes Gitter, sondern auch einzelne Kontaktfinger oder eine andere zur Kontaktierung geeignete Führung von Metallstegen zu verstehen. Durch ein solches Gitter werden die Probleme der Stromaufweitung bei strukturierten Lichtemissionsdioden überwunden und die verbesserte Lichtauskopplung kommt voll zum Tragen.

Die vertikale Strukturierung der Oberfläche der Stromaufweitungsschicht kann jede nur denkbare Form aufweisen. Mögliche Strukturen sind beispielsweise n-seitige Prismen, Pyramiden oder Pyramidenstümpfe, Zylinder, Kegel, Kegelstümpfe und dergleichen.

Die zweite elektrische Kontaktschicht kann sowohl auf strukturierten als auch auf unstrukturierten Abschnitten der Oberfläche der Stromaufweitungsschicht angeordnet sein.

Die Erfindung wird im folgenden in Verbindung mit den Zeichnungen näher erläutert. Es zeigen:
- Fig. 1: eine schematische, vereinfachte Querschnittsdarstellung einer in einem Reflektor angeordneten oberflächenstrukturierten Lichtemissionsdiode;
- Fig. 2: ein erstes Vergleichsbeispiel einer nicht erfindungsgemäßen zweiten elektrischen Kontaktschicht in einer Draufsicht auf die strukturierte Lichtaustrittsfläche der Lichtemissionsdiode;
- Fig. 3: ein zweites Vergleichsbeispiel einer nicht erfindungsgemäßen zweiten elektrischen Kontaktschicht in einer Draufsicht auf die strukturierte Lichtaustrittsfläche;
- Fig. 4: ein Ausführungsbeispiel einer zweiten elektrischen Kontaktschicht gemäß der Erfindung.

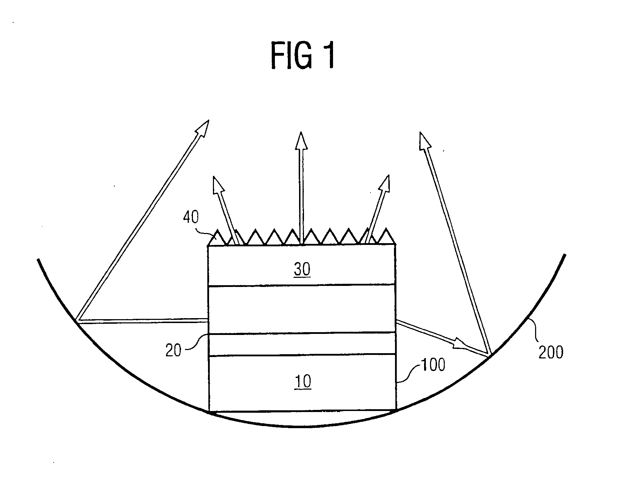

Die Fig. 1 zeigt einen LED-Chip 100, wie er in einem im Querschnitt kreis- oder parabelförmigen Reflektor 200 angeordnet ist, so daß die von ihm emittierten Lichtstrahlen sowohl auf direktem Wege abgestrahlt werden als auch durch den Reflektor 200 gesammelt und im wesentlichen in dieselbe Richtung emittiert werden. Im allgemeinen ist der LED-Chip 100 in einem Harzvergußmaterial eingebettet, so daß insbesondere an seiner lichtaustrittsseitigen Oberfläche eine Grenzfläche zwischen Halbleitermaterial und Harzvergußmaterial besteht. An dieser Grenzfläche existiert ein relativ großer Brechungsindexsprung, so daß bereits bei relativ geringen Einfallswinkeln zur Normalen eine Totalreflexion eintritt. Diese totalreflektierten Strahlen sollen nach Möglichkeit durch die Seitenwände des LED-Chips 100 ausgekoppelt werden und von dem Reflektor 200 gesammelt werden können, anstatt in dem Substrat des LED-Chips 100 absorbiert zu werden.

Eine erfindungsgemäße Lichtemissionsdiode weist eine Halbleiterschichtstruktur mit einem lichtabsorbierenden oder transparenten Substrat 10 und mindestens einer auf dem Substrat 10 geformten lichterzeugenden Schicht 20 auf. Die lichterzeugende Schicht 20 wird durch einen pn-Übergang gebildet. Falls gewünscht, kann eine Einfach- oder Mehrfach-Quantentrogstruktur als lichterzeugende Schicht 20 vorgesehen sein. Oberhalb der lichterzeugenden Schicht 20 wird eine relativ dicke, transparente Halbleiterschicht, die sogenannte Stromaufweitungsschicht 30 aufgewachsen. Auf der Substratrückseite ist eine erste elektrische Kontaktschicht ganzflächig aufgebracht, während auf einem Abschnitt der Stromaufweitungsschicht 30 eine zweite elektrische Kontaktschicht 50 aufgebracht ist. Die Oberfläche der Stromaufweitungsschicht 30 weist eine Strukturierung 40 auf, durch die die Lichtauskopplung verbessert werden soll. In der Querschnittsansicht der Fig. 1 ist die Strukturierung 40 als eine Mehrzahl von Pyramiden dargestellt. Diese Pyramiden können n ≥ 3 Seiten aufweisen, wobei im Grenzfall n = ∞ aus der Pyramide ein Kegel wird. Von dem entstehenden Gebilde kann auch die Spitze abgeschnitten werden, so daß ein Pyramidenstumpf oder ein Kegelstumpf entsteht. Auf die mit der Strukturierung 40 versehene Oberfläche der Stromaufweitungsschicht 30 wird eine zweite elektrische Kontaktschicht 50 derart aufgebracht, daß eine möglichst homogene Stromeinkopplung erzielt werden kann. Zu diesem Zweck wird die zweite elektrische Kontaktschicht 50 mit einer gitterförmigen Struktur aufgebracht.

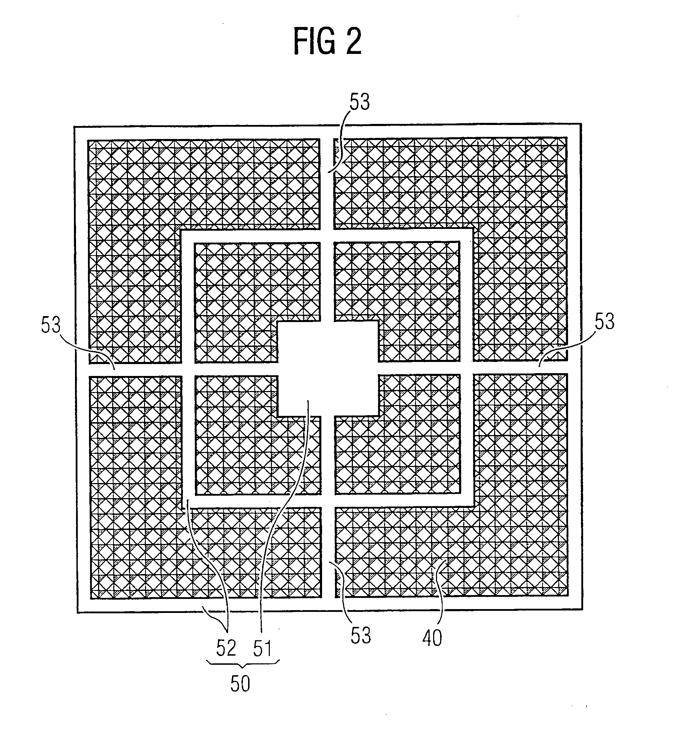

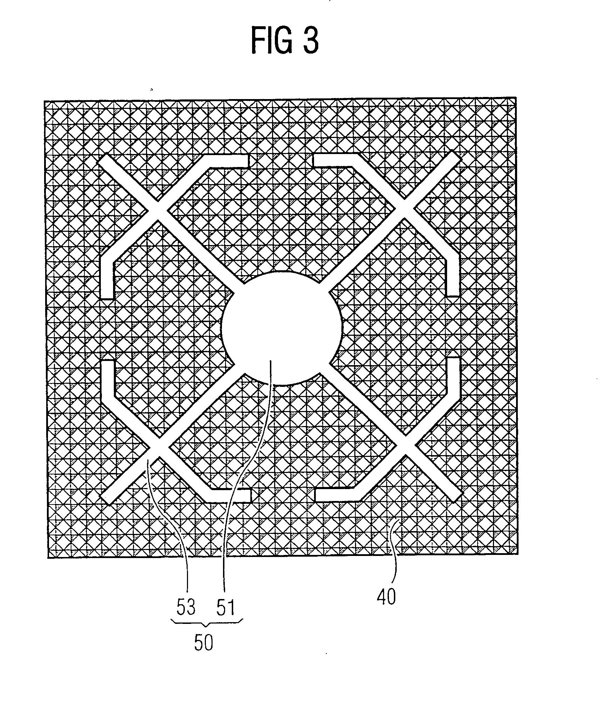

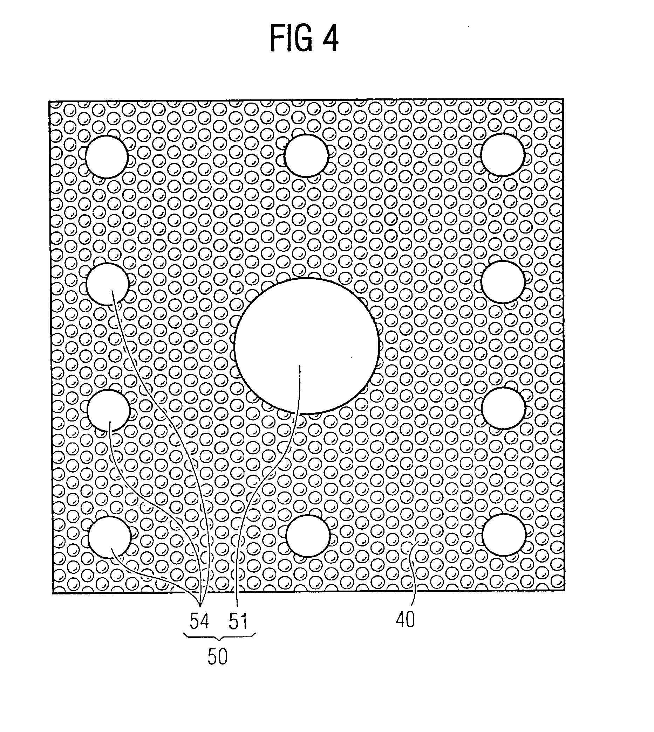

In den Fig. 2 und 3 sind nicht erfindungsgemäße Vergleichsbeispiele der zweiten elektrischen Kontaktschicht dargestellt. In Fig. 4 ist ein Ausführungsbeispiel für die Form der zweiten elektrischen Kontaktschicht gemäß der Erfindung dargestellt.

In den Fig. 2 bis 4 ist jeweils eine quadratisch geformte Lichtemissionsdiode in einer Draufsicht auf ihre Lichtaustrittsseite, d.h. auf die Oberfläche der mit der zweiten elektrischen Kontaktschicht 50 versehenen Stromaufweitungsschicht 30, dargestellt. In dem Beispiel der Fig. 2 besteht die Strukturierung 40 aus einer Mehrzahl von matrixförmig angeordneten vierseitigen Pyramiden oder Pyramidenstümpfen. Die zweite elektrische Kontaktschicht 50 kann generell entweder auf unstrukturierten Bereichen der Oberfläche der Stromaufweitungsschicht 30, also am Boden der Pyramiden, abgeschieden sein. Sie kann jedoch auch auf die Strukturierung 40 direkt aufgebracht sein. Vorzugsweise besteht die zweite elektrische Kontaktschicht 50 aus einer Kontaktlegierung, wie Au:Zn oder Au:Ge oder dergleichen. Die Beispiele der Fig. 2 bis 4 zeigen mögliche Formen der Struktur der zweiten elektrischen Kontaktschicht 50, die aus einer zentralen, insbesondere kreisrunden oder quadratischen Kontaktfläche 51 und einer zu dem Mittelpunkt der zentralen Kontaktfläche 51 rotationssymmetrischen Gitterstruktur aus relativ schmalen Kontaktstegen 52, 53 oder Kontaktpunkten 54 um die zentrale Kontaktfläche 51 herum bestehen. Um eine möglichst homogene Einkopplung des elektrischen Stroms zu erzielen, weist die Gitterstruktur der zweiten elektrischen Kontaktschicht 50 dabei eine eben solche Rotationssymmetrie wie die Lichtemissionsdiode selbst auf. Wenn daher die Lichtemissionsdiode wie in den Beispielen quadratisch geformt ist, somit vierzählige Symmetrie aufweist, so ist die Gitterstruktur der zweiten elektrischen Kontaktschicht 50 ebenfalls mit vierzähliger Rotationssymmetrie um den Mittelpunkt der zentralen Kontaktfläche 51 geformt.

Bei dem Beispiel der Fig. 2 weist die Kontaktschicht 50 einen äußeren und einen inneren umlaufenden Kontaktsteg 52 auf. Der äußere umlaufende Kontaktsteg 52 verläuft entlang dem Rand des Substrat 10. Der innere umlaufende Kontaktsteg 52 ist zwischen der zentralen Kontaktfläche 51 und dem äußeren umlaufenden Kontaktsteg 52 angeordnet. Der äußere umlaufende Kontaktsteg 52 und der innere umlaufende Kontaktsteg 52 sind untereinander und mit der zentralen Kontaktfläche 51 über in radiale Richtung verlaufende Kontaktstege 53 verbunden.

Die Gitterstruktur der zweiten elektrischen Kontaktschicht 50 ist bei den nicht erfindungsgemäßen Vergleichsbeispielen der Fig. 2 und 3 als zusammenhängende Struktur ausgebildet.

Bei dem in Fig. 4 dargestellten Ausführungsbeispiel der Erfindung ist die Struktur nicht zusammenhängend. Hier weist die Gitterstruktur eine kreisrunde zentrale Kontaktfläche 51 auf, die in vierzähliger Symmetrie von kreisrunden Kontaktpunkten 54 umgeben ist, die nicht direkt mit der zentralen Kontaktfläche 51 zusammenhängen. Um gleichwohl für derartige Ausführungsbeispiele einen elektrischen Kontakt zwischen den nicht zusammenhängenden Abschnitten der zweiten elektrischen Kontaktschicht 50 herzustellen, wird nach dem Einlegieren der Kontaktflächen 51 und 54 eine zusätzliche dünne transparente elektrisch leitfähige Schicht, beispielsweise aus Indiumzinnoxid (ITO) auf die Struktur abgeschieden.Die Gitterstruktur der zweiten elektrischen Kontaktschicht 50 kann aber auch anders geformt sein, beispielsweise eine Mäanderstruktur oder dergleichen aufweisen.

Die erfindungsgemäße Lichtemissionsdiode kann auf unterschiedliche Weise hergestellt werden. Da die zweite elektrische Kontaktschicht 50 im Prinzip auf der Strukturierung 40 abgeschieden werden kann, besteht die einfachste Herstellungsweise darin, zunächst die Oberfläche der Stromaufweitungsschicht 30 mit den beschriebenen Möglichkeiten zu strukturieren und anschließend die zweite elektrische Kontaktschicht 50 durch eine Schattenmaske, die einen Öffnungsbereich in der Form der gewünschten Struktur enthält, aufzudampfen oder in einen Sputter-Prozeß aufzubringen. Alternativ dazu kann auch die zweite elektrische Kontaktschicht 50 zunächst ganzflächig durch die genannten Prozesse aufgebracht werden und anschließend durch einen Lithographie- und Ätzschritt oder mittels Lift-Off-Technik strukturiert werden. Bei einer zweiten Herstellungsvariante wird die zweite elektrische Kontaktschicht 50 mit der gewünschten lateralen Struktur durch einen der vorgenannten Herstellungsprozesse auf die noch unstrukturierte Oberfläche der Stromaufweitungsschicht 30 aufgebracht und anschließend wird die vertikale Strukturierung der Oberfläche der Stromaufweitungsschicht 30 vorgenommen, wobei zu beachten ist, daß die zweite elektrische Kontaktschicht 50 nicht beschädigt wird.

## Patentansprüche

1. Lichtemissionsdiode (100), mit
- einer Halbleiterschichtstruktur enthaltend ein Substrat (10) und mindestens eine auf dem Substrat (10) geformte lichterzeugende Schicht (20) und eine auf die lichterzeugende Schicht (20) aufgebrachte, transparente Stromaufweitungsschicht (30),
- einer ersten elektrischen Kontaktschicht auf der Substratrückseite, und
- einer zweiten elektrischen Kontaktschicht (50), die auf der Stromaufweitungsschicht (30) angeordnet ist, wobei die zweite elektrische Kontaktschicht (50) eine laterale Struktur mit einer zentralen Kontaktfläche (51) und einer zu dem Mittelpunkt der zentralen Kontaktfläche (51) rotationssymmetrischen Kontaktstruktur (52; 53; 54) aus schmalen Kontaktstegen (52; 53) und/oder Kontaktpunkten (54) aufweist, die eine im wesentlichen homogene Einkopplung des elektrischen Stromes in die Stromaufweitungsschicht bewirkt,
**dadurch gekennzeichnet, daß**
- die Oberfläche der Stromaufweitungsschicht (30) eine vertikale Strukturierung (40) zur Verbesserung der Lichtauskopplung aufweist, und
- die zweite elektrische Kontaktschicht (50) in sich nicht zusammenhängend ist und die nicht zusammenhängenden Abschnitte der zweiten Kontaktschicht durch eine zusätzliche transparente, leitfähige Materialschicht untereinander verbunden sind.

2. Lichtemissionsdiode (100) nach Anspruch 1,
**dadurch gekennzeichnet, daß** die Rotationssymmetrie ganzzahlig ist und insbesondere der Rotationssymmetrie der Lichtemissionsdiode entspricht.

3. Lichtemissionsdiode (100) nach mindestens einem der vorhergehenden Ansprüche,
**dadurch gekennzeichnet, daß** die zentrale Kontaktschicht kreisrund oder quadratisch ist.

4. Lichtemissionsdiode (100) nach mindestens einem der vorhergehenden Ansprüche,
**dadurch gekennzeichnet, daß** die zusätzliche transparente leitfähige Schicht eine Indiumzinnoxidschicht ist.

5. Lichtemissionsdiode (100) nach mindestens einem der vorhergehenden Ansprüche,
**dadurch gekennzeichnet, daß** die zweite elektrische Kontaktschicht (50) auf strukturierten und/oder unstrukturierten Abschnitten der Stromaufweitungsschicht angeordnet ist.

6. Lichtemissionsdiode (100) nach mindestens einem der vorhergehenden Ansprüche,
**dadurch gekennzeichnet, daß** die vertikale Strukturierung (40) die Form von n-seitigen (n ≥ 3) Pyramiden, Pyramidenstümpfen, Kegeln oder Kegelstümpfen aufweist.

7. Verfahren zur Herstellung einer Lichtemissionsdiode (100) nach einem der vorhergehenden Ansprüche,
bei dem
- auf einem Substrat (10) eine lichterzeugende Schicht (20) und anschließend eine relativ dicke und transparente Stromaufweitungsschicht (30) aufgebracht wird und die Substratrückseite mit einer ersten elektrischen Kontaktschicht versehen wird,
- in der Oberfläche der Stromaufweitungsschicht (30) eine vertikale Strukturierung (40) zur Verbesserung der Lichtauskopplung erzeugt wird,
- auf die strukturierte Oberfläche der Stromaufweitungsschicht (30) eine zweite elektrische Kontaktschicht (50) mit einer lateralen Struktur mit einer zentralen Kontaktfläche (51) und einer zu dem Mittelpunkt der zentralen Kontaktfläche (51) rotationssymmetrischen Kontaktstruktur (52; 53; 54) aus schmalen Kontaktstegen (52; 53) und/oder Kontaktpunkten (54) aufgebracht wird, die in sich nicht zusammenhängend ist, und
- zum Verbinden der in sich nicht zusammenhängenden Abschnitte der zweiten Kontaktschicht eine zusätzliche transparente leitfähige Schicht aufgebracht wird.

8. Verfahren zur Herstellung einer Lichtemissionsdiode (100) nach einem der vorhergehenden Ansprüche,
bei dem
- auf einem Substrat (10) eine lichterzeugende Schicht (20) und anschließend eine relativ dicke und transparente Stromaufweitungsschicht (30) aufgebracht wird und die Substratrückseite mit einer ersten elektrischen Kontaktschicht versehen wird,
- auf die Oberfläche der Stromaufweitungsschicht (30) eine zweite elektrische Kontaktschicht (50) mit einer lateralen Struktur mit einer zentralen Kontaktfläche (51) und einer zu dem Mittelpunkt der zentralen Kontaktfläche (51) rotationssymmetrischen Kontaktstruktur (52; 53; 54) aus schmalen Kontaktstegen (52; 53) und/oder Kontaktpunkten (54) aufgebracht wird, die in sich nicht zusammenhängend ist, aufgebracht wird,
- in der Oberfläche der Stromaufweitungsschicht (30) eine vertikale Strukturierung (40) außerhalb der Bereiche der zweiten elektrischen Kontaktschicht (50) zur Verbesserung der Lichtauskopplung erzeugt wird, und
- zum Verbinden der in sich nicht zusammenhängenden Abschnitte der zweiten Kontaktschicht eine zusätzliche transparente leitfähige Schicht aufgebracht wird.

## Claims

1. Light-emitting diode (100), comprising
- a semiconductor layer structure containing a substrate (10) and at least one light-generating layer (20) shaped on the substrate (10) and a transparent current spreading layer (30) applied to the light-generating layer (20),
- a first electrical contact layer on the rear side of the substrate, and
- a second electrical contact layer (50) arranged on the current spreading layer (30), wherein the second electrical contact layer (50) has a lateral structure comprising a central contact area (51) and a contact structure (52; 53; 54) composed of narrow contact webs (52; 53) and/or contact points (54), said contact structure being rotationally symmetrical with respect to the midpoint of the central contact area (51), the lateral structure bringing about a substantially homogeneous coupling of the electric current into the current spreading layer,
**characterized in that**
- the surface of the current spreading layer (30) has a vertical structuring (40) for improving the coupling-out of light, and
- the second electrical contact layer (50) is inherently not continuous and the non-continuous portions of the second contact layer are interconnected by an additional transparent, conductive material layer.

2. Light-emitting diode (100) according to Claim 1,
**characterized in that**
the rotational symmetry is integral and corresponds, in particular, to the rotational symmetry of the light-emitting diode.

3. Light-emitting diode (100) according to at least one of the preceding claims,
**characterized in that**
the central contact layer is circular or square.

4. Light-emitting diode (100) according to at least one of the preceding claims,
**characterized in that**
the additional transparent conductive layer is an indium tin oxide layer.

5. Light-emitting diode (100) according to at least one of the preceding claims,
**characterized in that**
the second electrical contact layer (50) is arranged on structured and/or unstructured portions of the current spreading layer.

6. Light-emitting diode (100) according to at least one of the preceding claims,
**characterized in that**
the vertical structuring (40) has the shape of n-sided (n ≥ 3) pyramids, truncated pyramids, cones or truncated cones.

7. Method for producing a light-emitting diode (100) according to any of the preceding claims,
wherein
- on a substrate (10) a light-generating layer (20) is applied and then a relatively thick and transparent current spreading layer (30) is applied and the rear side of the substrate is provided with a first electrical contact layer,
- a vertical structuring (40) for improving the coupling-out of light is produced in the surface of the current spreading layer (30),
- a second electrical contact layer (50) having a lateral structure comprising a central contact area (51) and a contact structure (52; 53; 54) composed of narrow contact webs (52; 53) and/or contact points (54), said contact structure being rotationally symmetrical with respect to the midpoint of the central contact area (51), is applied to the structured surface of the current spreading layer (30), which second electrical contact layer is inherently not continuous, and
- an additional transparent conductive layer is applied for the purpose of connecting the inherently non-continuous portions of the second contact layer.

8. Method for producing a light-emitting diode (100) according to any of the preceding claims,
wherein
- on a substrate (10) a light-generating layer (20) is applied and then a relatively thick and transparent current spreading layer (30) is applied and the rear side of the substrate is provided with a first electrical contact layer,
- a second electrical contact layer (50) having a lateral structure comprising a central contact area (51) and a contact structure (52; 53; 54) composed of narrow contact webs (52; 53) and/or contact points (54), said contact structure being rotationally symmetrical with respect to the midpoint of the central contact area (51), is applied to the surface of the current spreading layer (30), which second electrical contact layer is inherently not continuous,
- a vertical structuring (40) is produced in the surface of the current spreading layer (30) outside the regions of the second electrical contact layer (50) for the purpose of improving the coupling-out of light, and
- an additional transparent conductive layer is applied for the purpose of connecting the inherently non-continuous portions of the second contact layer.

## Revendications

1. Diode électroluminescente (100), comprenant
- une structure de couche de semi-conducteur comportant un substrat (10) et au moins une couche génératrice de lumière (20) formée sur le substrat (10) et une couche de diffusion de courant transparente (30) déposée sur la couche génératrice de lumière (20),
- une première couche de contact électrique sur la face arrière du substrat, et
- une seconde couche de contact électrique (50), disposée sur ladite couche de diffusion de courant (30), la seconde couche de contact électrique (50) présentant une structure latérale ayant une surface de contact centrale (51) et une structure de contact symétrique de révolution (52 ; 53 ; 54) par rapport au point milieu de la surface de contact centrale (51) et constituée de bandes de contact étroites (52 ; 53) et/ou de points de contact (54), laquelle structure latérale provoque un couplage en entrée sensiblement homogène du courant électrique dans la couche de diffusion de courant,
**caractérisée en ce que**
- la surface de la couche de diffusion de courant (30) présente une structuration verticale (40) pour améliorer le couplage en sortie de la lumière, et
- la seconde couche de contact électrique (50) n'est pas d'un seul tenant et les parties qui ne sont pas d'un seul tenant de la seconde couche de contact sont connectées les unes aux autres par une couche de matériau conductrice transparente supplémentaire.

2. Diode électroluminescente (100) selon la revendication 1, **caractérisée en ce que**
la symétrie de rotation est entière et correspond notamment à la symétrie de rotation de la diode électroluminescente.

3. Diode électroluminescente (100) selon au moins l'une des revendications précédentes, **caractérisée en ce que**
la couche de contact centrale est circulaire ou carrée.

4. Diode électroluminescente (100) selon au moins l'une des revendications précédentes, **caractérisée en ce que**
la couche conductrice transparente supplémentaire est une couche d'oxyde d'indium-étain.

5. Diode électroluminescente (100) selon au moins l'une des revendications précédentes, **caractérisée en ce que**
la seconde couche de contact électrique (50) est disposée sur des parties structurées et/ou non structurées de la couche de diffusion de courant.

6. Diode électroluminescente (100) selon au moins l'une des revendications précédentes, **caractérisée en ce que**
la structuration verticale (40) présente la forme de pyramides à n côtés (n ≥ 3), de pyramides tronquées, de cônes ou de cônes tronqués.

7. Procédé de fabrication d'une diode électroluminescente (100) selon l'une quelconque des revendications précédentes,
dans lequel
- une couche génératrice de lumière (20) suivie d'une couche de diffusion de courant relativement épaisse et transparente (30) sont déposées sur un substrat (10) et la face arrière du substrat est munie d'une première couche de contact électrique,
- une structuration verticale (40) est réalisée dans la surface de la couche de diffusion de courant (30) pour améliorer le couplage en sortie de la lumière,
- une seconde couche de contact électrique (50) présentant une structure latérale ayant une surface de contact centrale (51) et une structure de contact (52 ; 53 ; 54) symétrique de rotation par rapport au point milieu de la surface de contact centrale (51) et constituée de bandes de contact étroites (52 ; 53) et/ou de points de contact (54) est déposée sur la surface structurée de la couche de diffusion de courant (30), laquelle couche n'est pas d'un seul tenant, et
- une couche conductrice transparente supplémentaire est déposée pour connecter les parties qui ne sont pas d'un seul tenant de la seconde couche de contact.

8. Procédé de fabrication d'une diode électroluminescente (100) selon l'une quelconque des revendications précédentes,
dans lequel
- une couche génératrice de lumière (20) suivie d'une couche de diffusion de courant transparente et relativement épaisse (30) sont déposées sur un substrat (10) et la face arrière du substrat est munie d'une première couche de contact électrique,
- une seconde couche de contact électrique (50) présentant une structure latérale ayant une surface de contact centrale (51) et une structure de contact (52 ; 53 ; 54) symétrique de rotation par rapport au point milieu de la surface de contact (51) et constituée de bandes de contact étroites (52 ; 53) et/ou de points de contact (54) est déposée sur la surface de la couche de diffusion de courant (30), laquelle couche n'est pas d'un seul tenant,
- une structuration verticale (40) est réalisée dans la surface de la couche de diffusion de courant (30) à l'extérieur de la région de la seconde couche de contact électrique (50) pour améliorer le couplage en sortie de la lumière, et
- une couche conductrice transparente supplémentaire est déposée pour connecter les parties qui ne sont pas d'un seul tenant de la seconde couche de contact.
